# EUROPEAN PATENT SPECIFICATION

(11) **EP 2 577 941 B1**
(45) Date of publication and mention of the grant of the patent: **26.02.2014**
(21) Application number: 11722595.3
(22) Date of filing: 24.05.2011
(51) Int. Cl.: H04L 29/08, H04L 12/10, G06F 1/32, G06F 1/20, H05K 7/14

(54) **ENERGY SELF-SUFFICIENT DATACENTER FOR PROCESSING AND STORAGE OF CLASSIFIED DATA**
ENERGIEAUTARKES DATENCENTER ZUM VERARBEITEN UND SPEICHERN VON KLASSIERTEN DATEN
CENTRE DE DONNÉES AUTOSUFFISANT EN ÉNERGIE DE TRAITEMENT ET DE STOCKAGE DE DONNÉES CLASSÉES

(30) Priority: 25.05.2010 NL 2004765
(43) Date of publication of application: 10.04.2013
(73) Proprietor: Stichting Palmofthehand, 3962 TJ Wijk Bij Duurstede (NL)
(72) Inventor: BERTRAM, Frank Jan, NL-3962 TJ Wijk Bij Duurstede (NL); KOPERBERG, Barry, Willem, Ferdinand, NL-1394 PA Nederhorst Den Berg (NL); RAU, Thomas, Martin, NL-1251 AK Laren (NL)
(74) Representative: Mertens, Hans Victor
(86) International application number: PCT/NL2011/050353
(87) International publication number: WO 2011/149343

(56) References cited:
- US-A1- 2002 156 899
- US-A1- 2002 191 553
- US-A1- 2004 081 135
- US-A1- 2007 014 278
- US-A1- 2007 237 128
- BERTINI L ET AL: "Power optimization for dynamic configuration in heterogeneous web server clusters", JOURNAL OF SYSTEMS & SOFTWARE, ELSEVIER NORTH HOLLAND, NEW YORK, NY, US, vol. 83, no. 4, 4 November 2009 (2009-11-04), pages 585-598, XP026914985, ISSN: 0164-1212, DOI: DOI:10.1016/J.JSS.2009.10.040 [retrieved on 2009-11-04]

## Description

### FIELD OF THE INVENTION

The invention relates to the field of data processing, storage and routing, and more specifically to such processes in a data center as part of an energy harvesting and exchange network.

### BACKGROUND OF THE INVENTION

In the following, a data center is a facility used to house computer systems and associated components, such as telecommunications and storage systems. It generally includes redundant or backup power supplies, redundant data communications connections, environmental controls (e.g., air conditioning, fire suppression) and security devices. A data center can occupy one room of a building, one or more floors, or an entire building. Most of the equipment is often in the form of servers mounted in cabinets, which are usually placed in single rows forming corridors between them. This allows people access to the front and rear of each cabinet. Servers differ greatly in size from one unit servers to large freestanding storage silos which occupy many tiles on the floor. Some equipment such as mainframe computers and storage devices are often as big as the racks themselves, and are placed alongside them.

With data centers expanding in numbers and capacity in attempt to keep pace with uncontrolled exponential growth of online data processing, in particular the demand for processing power and storage, the field of data processing faces big challenges. Data centers become more and more notorious for huge energy consumption, doubling every five years, and a corresponding CO₂ emission. Data centers add to the greenhouse effect and use up resources that are becoming scarce and unpredictably expensive.

In the current largely fossil-fuel power systems, electricity is generated from fossil energy with an average efficiency of about 35%. Due to transmission and transformation losses, about 95% of the generated electrical energy arrives at a data center. At the datacenter, only about 40% of the input electrical energy is used to power IT equipment, whereas the remaining part is needed to cover power infrastructure and cooling losses. In the IT equipment, servers use about 65% of the input electrical energy, whereas the remaining part is used in network equipment and storage equipment. In the servers, the central processing unit (CPU) uses on average 30% of the input electrical energy, whereas the remaining part is used by power supplies and other components. In a CPU, on average 80% of the time the CPU is idle, producing no useful data processing. In summary, in the end, less than 1% of the energy contained in the fuel is converted to useful work at CPU level. Most energy is spent on facilities such as cooling, climate control, lighting, and - above all - power conversions, before it can enter its actual workspace: the chip, disk, or switch. There it is converted into heat with 100% effectiveness. But instead of reusing this energy, it is taken for granted that energy output - heat cooled away from the racks - disappears into thin air.

As for energy reuse and supply, data centers are only beginning to be built in the vicinity of waste-heat consumers such as nursing homes or greenhouses, or, alternatively, close to producers of otherwise 'wasted cold' such as gas compression stations. Still, entirely 'greening' energy generation for data centers is problematic using current sustainable or renewable concepts. One single average rack in a data center would need over 1,000 square meters of commodity photovoltaic devices, or 40,000 square meters for biomass production. Other links in the power loss chain are also seldom addressed. Data accumulation is straightforwardly met with increased capacity. Over-dimensioning and redundant hardware and facilities, including backups, are common in data center design, resulting in efficiency losses. Guidelines for ambient temperature are on the safest possible side, demanding huge cooling efforts. Day-to-day business continuity is top priority.

### SUMMARY OF THE INVENTION

It would be desirable to provide a system of data processing based on a data center design, while meeting the highest standards in sustainability without sacrificing performance, reliability, and features.

It would also be desirable to provide a system of data processing based on a data center design which is sustainable and energy-neutral, and wherein
- internal energy demand and dissipation is reduced as far as possible;
- the external energy input/output balance is optimized, reusing heat produced within surrounding systems, while generating all of the energy needed from renewable resources, preferably on-site or within a smart green grid, without or with direct carbon neutral footprint; and/or
- relevant economical, legal, and social parameters in the environment can be taken into account.

It would also be desirable to provide a system of data processing based on a data center design, capable of
- processing more data using less energy;
- storing more data using less energy;
- getting the same useful work (processing and storage) using less overhead;
- reusing more of the waste heat; and/or
- harvesting the remaining energy renewably while using as little surface as possible.

To better address one or more of these concerns, in a first aspect of the invention a datacenter according to claim 1 is provided.

Datacenters for processing, storing and routing data between different data center modules according to data packet priorities and classification of data types or content types are known, for example, from documents:
- D1: US 2004/081135 A1 (EWING RICHARD E [US] ET AL) 29 April 2004 (2004-04-29);
- D2: US 2007/237128 A1 (PATEL NILESH V [US] ET AL) 11 October 2007 (2007-10-11);
- D3: US 2007/014278 A1 (EBBESEN BJORN [DE] ET AL) 18 January 2007 (2007-01-18).

An advantage of the datacenter according to the present invention is that data is classified and optimally stored and processed in a distributed and virtual manner, whereby each of the first, second and third datacenter modules is optimized to handle a specific data type. A first type of data which is stored and changed with a high frequency (at least once per day), is handled by a first datacenter module containing processing equipment which is configured to have a high performance. A second type of data which is stored and changed with a low frequency (seldom), is handled by a second datacenter module containing processing equipment which is configured to have a medium performance. A third type of data which is virtually permanently stored and almost never changed, is handled by a third datacenter module containing processing equipment which is configured to have a low performance.

In accordance with the present invention, data processed in the datacenter is classified to determine whether it is first type of data, second type of data, or third type of data, and the classified data is transferred to the datacenter module which is optimally suited to handle the specific type of data. Thus, a first type of data which is identified in the second datacenter module or the third datacenter module, is not kept in the second datacenter module or the third datacenter module, respectively, but is transferred through the datacenter network to the first datacenter module which is optimally suited for handling the first type of data. Similarly, a second type of data which is identified in the first datacenter module or the third datacenter module, is not kept in the first datacenter module or the third datacenter module, respectively, but is transferred through the datacenter network to the second datacenter module which is optimally suited for handling the second type of data. Finally, a third type of data which is identified in the first datacenter module or the second datacenter module, is not kept in the first datacenter module or the second datacenter module, respectively, but is transferred to the third datacenter module which is optimally suited for handling the third type of data.

A classification processing system can classify data streams real-time. The classification of data streams to determine first, second and third types of data, is known as such. After classification and segmentation, data is de-duplicated, consolidated, and stored separately on appropriate media in the first datacenter module, the second datacenter module, or the third datacenter module. Data can change classifications from the first type of data to the second type of data to the third type of data, but e.g. the second or third type of data can also become the first type of data at times.

Here, high performance of processing and storage equipment is defined as having a higher performance than medium or low performance. Medium performance of processing and storage equipment is defined as having a lower performance than high performance, but having a higher performance than low performance. Low performance of processing and storage equipment is defined as having a lower performance than high performance or medium performance. High, medium and low performances may be expressed in terms of MIPS or similar ratings.

The datacenter may comprise more than one, or a plurality of first datacenter modules, second datacenter modules or third datacenter modules, each connected to one another through the datacenter network, and together forming the datacenter. The number of first, second and third datacenter modules may vary according to the applications run in the datacenter by the multiplicity of users.

According to the invention, the datacenter modules are supplied with electrical energy generated from sustainable sources, to obtain an energy self-sufficient data center which is energy/CO₂ neutral when measured over an extended time period. However, a general property of sustainable sources is their time-varying energy harvest, for example due to varying solar radiation amounts, varying wind flows, varying water flows, etc. On the other hand, demand for electrical and thermal energy fluctuates over time.

The suitability of a first, second and third datacenter module for storing and processing of a first, second and third type of data, respectively, is determined by considering available and/or required amounts of electrical and/or thermal energy at the locations of the first, second and third datacenter modules. Thus, first, second or third types of data are only transferred to a specific one of the first, second and third datacenter modules if the available and/or required amounts of electrical and/or thermal energy at the locations of the first, second and third datacenter modules support such transfer. If not, then the first, second or third types of data are transferred to one or more other ones of the first, second and third datacenter modules where the conditions of available and/or required amounts of energy are met. Accordingly, in the datacenter according to the present invention, data follows energy, and on average, as seen over a time period, the processing and storage of data in the datacenter may be energy self-sufficient or energy neutral.

In an embodiment, wherein at least one of the first, second and third datacenter modules is supplied with a time-varying amount of electrical energy, the transfer of each of the first, second and third types of data to the one of the first, second and third datacenter modules at a predetermined time is based on the available electrical energy at the one of the first, second and third datacenter modules at the predetermined time.

In another embodiment, wherein at least one of the first, second and third datacenter modules generates a time-varying amount of thermal energy, the transfer of each of the first, second and third types of data to the one of the first, second and third datacenter modules at a predetermined time is based on a demand of thermal energy in an environment of the one of the first, second and third datacenter modules.

Generally, the first datacenter module requires a high amount of energy per amount of data stored, whereas the second datacenter module requires a medium amount of energy per amount of data stored, and the third datacenter module requires a low amount of energy per amount of data stored. Classifying the data processed in the datacenter into first, second and third type of data, and handling such data in first, second and third datacenter modules, respectively, will allow the processing equipment installed in the first, second and third datacenter modules to be most efficient, e.g. energy-efficient, for the specific type of data. This lowers the amount of energy used by the datacenter dramatically.

In an embodiment, the first datacenter module, the second datacenter module, and the third datacenter module are physically separated and/or located remote from each other.

An advantage of this embodiment is that a first datacenter module may be located close to a user, e.g. a business or other organization, persons working in a building, or a business area. Since the first datacenter module will use relatively much energy due to its high performance equipment which is used to a large extent by virtue of the first type of data within the datacenter being directed to the first datacenter module (if preconditions of available and/or required energy are met, as explained above), a location of the first datacenter module close to a user allows for the use of thermal heat generated by the first datacenter in a district heating system serving the user and/or others nearby. In an embodiment, processors of the first datacenter module are fluid cooled, and at least part of the energy transferred from the processors to the fluid is used in district heating.

In a second aspect of the present invention, a method for processing, storing and routing data according to claim 12 is provided.

These and other aspects of the invention will be more readily appreciated as the same becomes better understood by reference to the following detailed description and considered in connection with the accompanying drawings in which like reference symbols designate like parts.

### BRIEF DESCRIPTION OF THE DRAWINGS

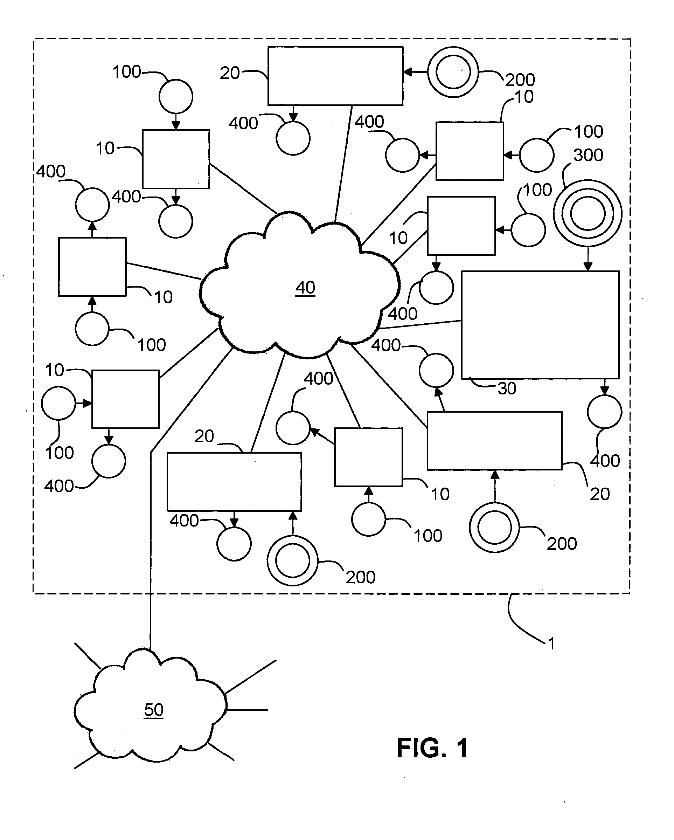

Figure 1 schematically depicts a datacenter comprising first, second and third datacenter modules in an embodiment of the present invention.

### DETAILED DESCRIPTION OF EMBODIMENTS

Figure 1 depicts a datacenter 1 (indicated by a dashed box) comprising a plurality of first datacenter modules 10, second datacenter modules 20, and third datacenter modules 30. The first datacenter modules 10, the second datacenter modules 20, and the third datacenter modules 30 are interconnected by a datacenter network 40, e.g. a fiber network, in a manner not shown in detail, for exchanging data between the different first, second and third datacenter modules 10, 20 and 30. The datacenter network 40 may be connected to, or be part of another network 50, e.g. the Internet, or a WLAN, which in turn may be connected to, or be part of other networks as indicated by several lines extending from network 50.

First datacenter modules 10 may be relatively small units or buildings having a footprint of e.g. 1-10 square meters or more, and being located close by a user or a group of users. Data is processed in the first datacenter module 10 by high performance processors to which tasks are allocated to have the processors work at 80% capacity or higher, while switching off processors that are not needed.

In the first datacenter modules 10 data are stored and retrieved which are used and changed intensively, i.e. at least once a day on average. This first type of data may be indicated as 'hot' data.

The first datacenter modules 10 are supplied with solar or wind generated energy fed into the general electricity grid, and/or from dedicated photovoltaic devices and/or dedicated wind turbines, as indicated with power sources 100. In an embodiment, the equipment at the first datacenter module 10 is configured to be supplied directly by DC voltage and current as generated by the dedicated photovoltaic devices and/or dedicated wind turbines, thereby avoiding conversion losses which would result from powering the first datacenter module 10 from an AC mains and transforming and rectifying the voltage to supply the equipment.

In an embodiment, the high capacity processors in the first datacenter module 10 are water-cooled, and the thermal energy thus generated in cooling fluid in the first datacenter module 10 is used for district heating in the district of one or more users located nearby the first datacenter module.

A suitable location for a first datacenter module 10 is in or on a local distribution building for electrical and/or thermal energy. The distribution building may be connected to the electrical power grid, and receive solar or wind generated electrical energy from the electrical power grid or from dedicated photovoltaic devices and/or dedicated wind turbines, which may be located near or on the first datacenter module 10. The distribution building may house a part of a district heating system, and the thermal energy generated in cooling fluid in the first datacenter module 10 may be used to supply thermal energy (heat) to one or more users through the district heating system, and fed into this system in the distribution building.

Summarizing, a typical first datacenter module is located near one or more users (e.g. in the midst of a housing estate or an industrial area), covering its (first type of) data processing and storing demand, drawing electric energy from the vicinity, and providing the vicinity with thermal energy. Buildings in the vicinity may be covered with photovoltaic cells, and wind generators may be provided in the vicinity, which deliver their power to the first datacenter module using the available electric grid.

Second datacenter modules 20 may be medium-sized units or buildings having a footprint of e.g. 5-20 square meters or more. The number of second datacenter modules 20 generally is less than the number of first datacenter modules 10 in the datacenter 1. Data is stored in the second datacenter module 20 using medium performance processors. Processors which are not needed, may be switched off.

In the second datacenter modules 20 data are stored and changed with a low frequency, i.e. seldom, less than once a day on average. This second type of data may be indicated as 'cold' data.

The second datacenter modules 20 are supplied with solar or wind generated energy fed into the general electricity grid, and/or from dedicated photovoltaic devices and/or dedicated wind turbines, as indicated with power sources 200. In an embodiment, the equipment at the second datacenter module 20 is configured to be supplied directly by DC voltage and current as generated by the dedicated photovoltaic devices and/or dedicated wind turbines, thereby avoiding conversion losses which would result from powering the second datacenter module 20 from an AC mains and transforming and rectifying the voltage to supply the equipment.

A second datacenter module 20 may be part of a bridge, e.g. a light pedestrians and bikers bridge, connecting different districts. The bridge may comprise a beam between the different districts, with the beam supported by piers at predetermined distances. The beam may be hollow, e.g. made from concrete, and contain fiber data cables and insulated water pipes. Each pier may comprise a second datacenter module 20. A wind generator, e.g. located at each pier, may provide energy to the second datacenter module. The number of piers, and therefore the total potential electric energy generating capacity of the bridge, depends on its length. Water heated by thermal energy generated in the second datacenter 20, e.g. at a rack level, is transported to one or either end of the bridge for storage in a geothermal system, or for district heating.

Summarizing, a typical second datacenter module need not be close to a user. A location can be chosen outside an area of users (housing estate or industrial area).

Third datacenter modules 30 may be large-sized units or buildings having a footprint of e.g. 100-2.000 square meters or more. The number of third datacenter modules 30 generally is less than the number of first datacenter modules 10 or the number of second datacenter modules 20 in the datacenter 1. Data is stored in the third datacenter 30 using low performance processors, and using memory devices requiring a minimum amount of energy when in use or when not in use. Processors which are not needed, may be switched off.

In the third datacenter modules 30 data are stored and changed almost never. This third kind of data may be indicated as 'frozen' data.

The third datacenter module 30 is supplied with energy generated from biomass, as indicated with power source 300. The third datacenter module 30 may be enclosed by an insulating envelope. Inside the envelope, air convection transports and accumulates heat from the racks to the roof, where it is cooled away adiabatically by a water grid. The resulting warm water is heated up by heat output from a biomass power plant, which generates at least part of the electrical energy needed to run the third datacenter module 30.

Summarizing, a typical third datacenter module may be situated at a remote location, e.g. in an elephant grass field, where the elephant grass provides the biomass used to generate gas for generating electric power for the third datacenter.

In the first, second and third datacenter modules 10, 20, 30, power is supplied by power sources 100, 200 and 300, respectively. Data is transferred to, and processed at the first, second and third datacenter modules 10, 20, 30 taking into account the available energy from the power sources 100, 200 and 300. If the available energy, including stored energy (e.g. stored in batteries or in thermal stores) is not sufficient to support the processing and storing of data in one datacenter module of a specific (first, second or third) type, another datacenter module (of the same type) may be found where there is sufficient or more than sufficient energy available to support the processing and storing of data there.

In the first, second and third datacenter modules 10, 20, 30, thermal power is generated (as indicated by thermal power outputs 400) by the processing and storing of data. Data is transferred to, and processed at the first, second and third datacenter modules 10, 20, 30 taking into account the thermal energy needed in the vicinity of the datacenter modules 10, 20, 30. If the needed thermal energy, including energy which can be stored (e.g. stored in thermal stores) is not sufficient to support the processing and storing of data in one datacenter module of a specific (first, second or third) type, another datacenter module (of the same type) may be found where there is sufficient or more thermal energy needed to support the processing and storing of data there.

As explained above, in a datacenter, data are processed, stored and routed. In the datacenter, a first datacenter module is configured for processing and storing a first type of data that is stored and changed with a high frequency. A second datacenter module is configured for processing and storing a second type of data that is stored and changed with a low frequency. A third datacenter module is configured for processing and storing a third type of data that is stored, and changed almost never. The first, second and third datacenter modules are interconnected through a datacenter network for routing and exchanging data between the first, second and third datacenter modules. The data processed in the datacenter are classified in the first type of data, the second type of data, and the third type of data by a classification processing system, transferring the first type of data identified in the second and third datacenter modules to the first datacenter module, transferring the second type of data identified in the first and third datacenter modules to the second datacenter module, and transferring the third kind of data identified in the first and second datacenter modules to the third datacenter module. The suitability of a first, second and third datacenter module for storing and processing of a first, second and third type of data, respectively, is determined by considering available and/or required amounts of electrical and/or thermal energy at the locations of the first, second and third datacenter modules.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting, but rather, to provide an understandable description of the invention.

The terms "a" or "an", as used herein, are defined as one or more than one. The term plurality, as used herein, is defined as two or more than two. The term another, as used herein, is defined as at least a second or more. The terms including and/or having, as used herein, are defined as comprising (i.e., open language, not excluding other elements or steps). Any reference signs in the claims should not be construed as limiting the scope of the claims or the invention.

The mere fact that certain measures are recited in mutually different dependent claims does not indicate that a combination of these measures cannot be used to advantage.

## Claims

1. A datacenter (1) for processing, storing and routing data, the datacenter comprising:
at least one first datacenter module (10), at least one second datacenter module (20), and at least one third datacenter module (30);
a datacenter network (40) interconnecting the first, second and third datacenter modules for routing and exchanging data between the first, second and third datacenter modules (10, 20, 30),
**characterized in that**
the first datacenter module (10) is configured for processing and storing a first type of data that is stored and changed with a high frequency;
the second datacenter module (20) is configured for processing and storing a second type of data that is stored and changed with a low frequency;
the third datacenter module (30) is configured for processing and storing a third type of data that is stored, and changed almost never,
wherein the datacenter further comprises:
a classification processing system for classifying the data processed in the datacenter (1) in the first type of data, the second type of data, and the third type of data, and transferring the first type of data identified in the second and third datacenter modules (20, 30) to the first datacenter module (10), transferring the second type of data identified in the first and third datacenter modules (10, 30) to the second datacenter module (20), and transferring the third kind of data identified in the first and second datacenter modules (10, 20) to the third datacenter module (30),
wherein at least one of the first, second and third datacenter modules (10, 20, 30) is supplied with a time-varying available amount of electrical energy, and transfer of each of the first, second and third types of data to the one of the first, second and third datacenter modules (10, 20, 30) at a predetermined time is based on the available electrical energy at the one of the first, second and third datacenter modules (10, 20, 30) at the predetermined time.

2. The datacenter (1) of claim 1, wherein at least one of the first, second and third datacenter modules (10, 20, 30) generates a time-varying amount of thermal energy, and the transfer of each of the first, second and third types of data to the one of the first, second and third datacenter modules (10, 20, 30) at a predetermined time is based on a demand of thermal energy in an environment of the one of the first, second and third datacenter modules (10, 20, 30).

3. The datacenter (1) of any of the preceding claims, wherein the first datacenter module, the second datacenter module, and the third datacenter module are located physically separated from each other.

4. The datacenter (1) of any of the preceding claims, wherein the first datacenter module (10), the second datacenter module (20), and the third datacenter module (30) are located remote from each other.

5. The datacenter (1) of any of the preceding claims, wherein the first datacenter module (10) comprises high performance processors and low access time memory devices.

6. The datacenter (1) of any of the preceding claims, wherein the second datacenter module (20) comprises medium performance processors and medium access time memory devices.

7. The datacenter (1) of any of the preceding claims, wherein the third datacenter module (30) comprises low performance processors and high access time memory devices.

8. The datacenter (1) of any of the preceding claims, wherein the energy used in the second datacenter module (20) is at least partly solar and/or wind energy.

9. The datacenter (1) of any of the preceding claims, wherein the energy used in the first or the second datacenter module (10, 20) is at least partly generated by a photovoltaic device or a wind generator in the form of DC supply power, and wherein processing equipment in the first or the second datacenter module is adapted to be fed with the DC supply power directly.

10. The datacenter (1) of any of the preceding claims, wherein the energy used in the third datacenter module (30) is at least partly generated from gas produced from biomass.

11. The datacenter (1) of any of the preceding claims, wherein the first datacenter module (10) is located near at least one user, and at least part of the waste heat of the first datacenter module (10) is used to heat a fluid distributed to the user.

12. The datacenter (1) of claim 11, wherein the first datacenter module (10) is connected to a district heating system.

13. A method for processing, storing and routing data in a datacenter (1), comprising:
providing at least one first datacenter module (10), at least one second datacenter module (20), and at least one third datacenter module (30);
interconnecting the first, second and third datacenter modules (10, 20, 30) for routing and exchanging data between the first, second and third datacenter modules (10, 20, 30),
the method being **characterized by**:
the first datacenter module (10) being configured for processing and storing a first type of data that is stored and changed with a high frequency;
the second datacenter module (20) being configured for processing and storing a second type of data that is stored and changed with a low frequency;
the third datacenter module (30) being configured for processing and storing a third type of data that is stored, and changed almost never;
classifying the data processed in the datacenter (1) in the first type of data, the second type of data, and the third type of data, and transferring the first type of data identified in the second and third datacenter modules (20, 30) to the first datacenter module (10), transferring the second type of data identified in the first and third datacenter modules (10, 30) to the second datacenter module (20), and transferring the third kind of data identified in the first and second datacenter modules (10, 20) to the third datacenter module (30); and
supplying at least one of the first, second and third datacenter modules (10, 20, 30) with a time-varying available amount of electrical energy, and transferring each of the first, second and third types of data to the one of the first, second and third datacenter modules (10, 20, 30) at a predetermined time based on the available electrical energy at the one of the first, second and third datacenter modules (10, 20, 30) at the predetermined time.

## Patentansprüche

1. Datencenter (1) zum Verarbeiten, Speichern und Weiterleiten von Daten, wobei das Datencenter umfasst:
mindestens ein erstes Datencentermodul (10), mindestens ein zweites Datencentermodul (20) und mindestens ein drittes Datencentermodul (30);
ein Datencenternetz (40), welches das erste, zweite und dritte Datencentermodul miteinander verbindet, zum Weiterleiten und Austauschen von Daten zwischen dem ersten, zweiten und dritten Datencentermodul (10, 20, 30),
**dadurch gekennzeichnet, dass**
das erste Datencentermodul (10) zum Verarbeiten und Speichern einer ersten Art von Daten ausgestaltet ist, welche mit einer hohen Frequenz gespeichert und geändert werden;
das zweite Datencentermodul (20) zum Verarbeiten und Speichern einer zweiten Art von Daten ausgestaltet ist, welche mit einer niedrigen Frequenz gespeichert und geändert werden;
das dritte Datencentermodul (30) zum Verarbeiten und Speichern einer dritten Art von Daten ausgestaltet ist, welche gespeichert und nahezu nie geändert werden,
wobei das Datencenter ferner umfasst:
ein Klassifikationsverarbeitungssystem zum Klassifizieren der in dem Datencenter (1) verarbeiteten Daten in die erste Art von Daten, die zweite Art von Daten und die dritte Art von Daten, und zum Übertragen der ersten Art von Daten, welche in dem zweiten und dritten Datencentermodul (20, 30) identifiziert werden, zu dem ersten Datencentermodul (10), zum Übertragen der zweiten Art von Daten, welche in dem ersten und dritten Datencentermodul (10, 30) identifiziert werden, zu dem zweiten Datencentermodul (20), und zum Übertragen der dritten Art von Daten, welche in dem ersten und zweiten Datencentermodul (10, 20) identifiziert werden, zu dem dritten Datencentermodul (30),
wobei mindestens eines von dem ersten, zweiten und dritten Datencentermodul (10, 20, 30) mit einer zeitveränderlichen verfügbaren Menge von elektrischer Energie versorgt wird, und wobei eine Übertragung von jeweils der ersten, zweiten und dritten Art von Daten zu einem von dem ersten, zweiten und dritten Datencentermodul (10, 20, 30) zu einer vorbestimmten Zeit auf der verfügbaren elektrischen Energie an dem einen von dem ersten, zweiten und dritten Datencentermodul (10, 20, 30) zu der vorbestimmten Zeit basiert.

2. Datencenter (1) nach Anspruch 1, wobei mindestens eines von dem ersten, zweiten und dritten Datencentermodul (10, 20, 30) eine zeitveränderliche Menge von thermischer Energie erzeugt, und wobei die Übertragung von jeder der ersten, zweiten und dritten Art von Daten zu dem einen von dem ersten, zweiten und dritten Datencentermodul (10, 20, 30) zu einer vorbestimmten Zeit auf einer Abnahme von thermischer Energie in einer Umgebung des einen von dem ersten, zweiten und dritten Datencentermodul (10, 20, 30) basiert.

3. Datencenter (1) nach einem der vorhergehenden Ansprüche, wobei das erste Datencentermodul, das zweite Datencentermodul und das dritte Datencentermodul physikalisch getrennt voneinander angeordnet sind.

4. Datencenter (1) nach einem der vorhergehenden Ansprüche, wobei das erste Datencentermodul (10), das zweite Datencentermodul (20) und das dritte Datencentermodul (30) entfernt voneinander angeordnet sind.

5. Datencenter (1) nach einem der vorhergehenden Ansprüche, wobei das erste Datencentermodul (10) Hochleistungsprozessoren und Speichervorrichtungen mit niedriger Zugriffszeit umfasst.

6. Datencenter (1) nach einem der vorhergehenden Ansprüche, wobei das zweite Datencentermodul (20) Prozessoren mit mittlerer Leistung und Speichervorrichtungen mit mittlerer Zugriffszeit umfasst.

7. Datencenter (1) nach einem der vorhergehenden Ansprüche, wobei das dritte Datencentermodul (30) Prozessoren mit niedriger Leistung und Speichervorrichtungen mit hoher Zugriffszeit umfasst.

8. Datencenter (1) nach einem der vorhergehenden Ansprüche, wobei die in dem zweiten Datencentermodul (20) verwendete Energie zumindest teilweise Solar- und/oder Windenergie ist.

9. Datencenter (1) nach einem der vorhergehenden Ansprüche, wobei die in dem ersten oder dem zweiten Datencentermodul (10, 20) verwendete Energie zumindest teilweise von einer photovoltaischen Vorrichtung oder einem Windengenerator in der Form einer Gleichspannungsversorgungsenergie erzeugt wird, und wobei eine Verarbeitungseinrichtung in dem ersten oder dem zweiten Datencentermodul ausgestaltet ist, mit der Gleichspannungsversorgungsenergie direkt versorgt zu werden.

10. Datencenter (1) nach einem der vorhergehenden Ansprüche, wobei die in dem dritten Datencentermodul (30) verwendete Energie zumindest teilweise aus Gas erzeugt wird, welches aus Biomasse hergestellt wird.

11. Datencenter (1) nach einem der vorhergehenden Ansprüche, wobei das erste Datencentermodul (10) in der Nähe von zumindest einem Benutzer angeordnet ist und zumindest ein Teil der Abwärme des ersten Datencentermoduls (10) verwendet wird, um ein dem Benutzer zugeteiltes Fluid zu erwärmen.

12. Datencenter (1) nach Anspruch 11, wobei das erste Datencentermodul (10) mit einem Fernwärmenetz verbunden ist.

13. Verfahren zum Verarbeiten, Speichern und Weiterleiten von Daten in einem Datencenter (1), umfassend:
Bereitstellen von mindestens einem ersten Datencentermodul (10), mindestens einem zweiten Datencentermodul (20) und mindestens einem dritten Datencentermodul (30);
Verbinden des ersten, zweiten und dritten Datencentermoduls (10, 20, 30) miteinander zum Weiterleiten und Austauschen von Daten zwischen dem ersten, zweiten und dritten Datencentermodul (10, 20, 30),
wobei das Verfahren **gekennzeichnet ist durch**:
wobei das erste Datencentermodul (10) zum Verarbeiten und Speichern einer ersten Art von Daten ausgestaltet ist, welche mit einer hohen Frequenz gespeichert und geändert werden;
wobei das zweite Datencentermodul (20) zum Verarbeiten und Speichern einer zweiten Art von Daten ausgestaltet ist, welche mit einer niedrigen Frequenz gespeichert und geändert werden;
wobei das dritte Datencentermodul (30) zum Verarbeiten und Speichern einer dritten Art von Daten ausgestaltet ist, welche gespeichert und nahezu nie geändert werden;
Klassifizieren der in dem Datencenter (1) verarbeiteten Daten in die erste Art von Daten, die zweite Art von Daten und die dritte Art von Daten, und Übertragen der ersten Art von Daten, welche in dem zweiten und dritten Datencentermodul (20, 30) identifiziert werden, zu dem ersten Datencentermodul (10), Übertragen der zweiten Art von Daten, welche in dem ersten und dritten Datencentermodul (10, 30) identifiziert werden, zu dem zweiten Datencentermodul (20), und Übertragen der dritten Art von Daten, welche in dem ersten und zweiten Datencentermodul (10, 20) identifiziert werden, zu dem dritten Datencentermodul (30); und
Versorgen von mindestens einem von dem ersten, zweiten und dritten Datencentermodul (10, 20, 30) mit einer zeitveränderlichen verfügbaren Menge von elektrischer Energie, und Übertragen von jeweils der ersten, zweiten und dritten Art von Daten zu dem einen von dem ersten, zweiten und dritten Datencentermodul (10, 20, 30) zu einer vorbestimmten Zeit basierend auf der verfügbaren elektrischen Energie an dem einen von dem ersten, zweiten und dritten Datencentermodul (10, 20, 30) zu der vorbestimmten Zeit.

## Revendications

1. Centre de données (1) de traitement, stockage et acheminement de données, le centre de données comprenant :
au moins un premier module de centre de données (10), au moins un deuxième module de centre de données (20), et au moins un troisième module de centre de données (30) ;
un réseau de centre de données (40) interconnectant les premier, deuxième et troisième modules de centre de données en vue d'acheminer et d'échanger des données entre les premier, deuxième et troisième modules de centre de données (10, 20, 30) ;
**caractérisé en ce que** :
le premier module de centre de données (10) est configuré de manière à traiter et à stocker un premier type de données qui sont stockées et modifiées avec une haute fréquence ;
le deuxième module de centre de données (20) est configuré de manière à traiter et à stocker un deuxième type de données qui sont stockées et modifiées avec une basse fréquence ;
le troisième module de centre de données (30) est configuré de manière à traiter et à stocker un troisième type de données qui sont stockées, et ne sont presque jamais modifiées ;
dans lequel le centre de données comprend en outre :
un système de traitement de classification destiné à classer les données traitées dans le centre de données (1) dans le premier type de données, le deuxième type de données, et le troisième type de données, et à transférer le premier type de données identifié dans les deuxième et troisième modules de centre de données (20, 30) vers le premier module de centre de données (10), à transférer le deuxième type de données identifié dans les premier et troisième modules de centre de données (10, 30) vers le deuxième module de centre de données (20), et à transférer le troisième type de données identifié dans les premier et deuxième modules de centre de données (10, 20) vers le troisième module de centre de données (30) ;
dans lequel au moins l'un des premier, deuxième et troisième modules de centre de données (10, 20, 30) est alimenté avec une quantité d'énergie électrique disponible variable dans le temps, et le transfert de chacun des premier, deuxième et troisième types de données vers ledit un des premier, deuxième et troisième modules de centre de données (10, 20, 30), à un instant prédéterminé, est basé sur l'énergie électrique disponible au niveau dudit un des premier, deuxième et troisième modules de centre de données (10, 20, 30) à l'instant prédéterminé.

2. Centre de données (1) selon la revendication 1, dans lequel au moins l'un des premier, deuxième et troisième modules de centre de données (10, 20, 30) génère une quantité d'énergie thermique disponible variable dans le temps, et le transfert de chacun des premier, deuxième et troisième types de données vers ledit un des premier, deuxième et troisième modules de centre de données (10, 20, 30) à un instant prédéterminé est basé sur une demande d'énergie thermique au sein d'un environnement dudit un des premier, deuxième et troisième modules de centre de données (10, 20, 30).

3. Centre de données (1) selon l'une quelconque des revendications précédentes, dans lequel le premier module de centre de données, le deuxième module de centre de données et le troisième module de centre de données sont séparés physiquement les uns des autres.

4. Centre de données (1) selon l'une quelconque des revendications précédentes, dans lequel le premier module de centre de données (10), le deuxième module de centre de données (20), et le troisième module de centre de données (30) sont situés à distance les uns des autres.

5. Centre de données (1) selon l'une quelconque des revendications précédentes, dans lequel le premier module de centre de données (10) comprend des processeurs à hautes performances et des dispositifs de mémoire à faible temps d'accès.

6. Centre de données (1) selon l'une quelconque des revendications précédentes, dans lequel le deuxième module de centre de données (20) comprend des processeurs à performances moyennes et des dispositifs de mémoire à temps d'accès moyen.

7. Centre de données (1) selon l'une quelconque des revendications précédentes, dans lequel le troisième module de centre de données (30) comprend des processeurs à faibles performances et des dispositifs de mémoire à temps d'accès élevé.

8. Centre de données (1) selon l'une quelconque des revendications précédentes, dans lequel l'énergie utilisée dans le deuxième module de centre de données (20) est au moins en partie de l'énergie solaire et/ou de l'énergie éolienne.

9. Centre de données (1) selon l'une quelconque des revendications précédentes, dans lequel l'énergie utilisée dans le premier ou le deuxième module de centre de données (10, 20) est au moins en partie générée par un dispositif photovoltaïque ou un générateur éolien sous la forme d'un bloc d'alimentation en courant c.c., et dans lequel un équipement de traitement dans le premier ou le deuxième module de centre de données est apte à être alimenté directement au moyen du bloc d'alimentation en courant c.c..

10. Centre de données (1) selon l'une quelconque des revendications précédentes, dans lequel l'énergie utilisée dans le troisième module de centre de données (30) est au moins en partie générée à partir de gaz produit à partir de la biomasse.

11. Centre de données (1) selon l'une quelconque des revendications précédentes, dans lequel le premier module de centre de données (10) est situé à proximité d'au moins un utilisateur, et au moins une partie de la chaleur résiduelle du premier module de centre de données (10) est utilisée afin de chauffer un fluide distribué à l'utilisateur.

12. Centre de données (1) selon la revendication 11, dans lequel le premier module de centre de données (10) est connecté à un système de chauffage urbain.

13. Procédé de traitement, stockage et acheminement de données dans un centre de données (1), consistant à :
fournir au moins un premier module de centre de données (10), au moins un deuxième module de centre de données (20), et au moins un troisième module de centre de données (30) ;
interconnecter les premier, deuxième et troisième modules de centre de données (10, 20, 30) en vue d'acheminer et d'échanger des données entre les premier, deuxième et troisième modules de centre de données (10, 20, 30) ;
le procédé étant **caractérisé en ce que** :
le premier module de centre de données (10) est configuré de manière à traiter et à stocker un premier type de données qui sont stockées et modifiées avec une haute fréquence ;
le deuxième module de centre de données (20) est configuré de manière à traiter et à stocker un deuxième type de données qui sont stockées et modifiées avec une basse fréquence ;
le troisième module de centre de données (30) est configuré de manière à traiter et à stocker un troisième type de données qui sont stockées, et ne sont presque jamais modifiées ; et **en ce qu'**il consiste à :
classer les données traitées dans le centre de données (1) dans le premier type de données, le deuxième type de données, et le troisième type de données, et transférer le premier type de données identifié dans les deuxième et troisième modules de centre de données (20, 30) vers le premier module de centre de données (10), transférer le deuxième type de données identifié dans les premier et troisième modules de centre de données (10, 30) vers le deuxième module de centre de données (20), et transférer le troisième type de données identifié dans les premier et deuxième modules de centre de données (10, 20) vers le troisième module de centre de données (30) ; et
fournir, à au moins l'un des premier, deuxième et troisième modules de centre de données (10, 20, 30), une quantité d'énergie électrique disponible variable dans le temps, et transférer chacun des premier, deuxième et troisième types de données vers ledit un des premier, deuxième et troisième modules de centre de données (10, 20, 30), à un instant prédéterminé, sur la base de l'énergie électrique disponible au niveau dudit un des premier, deuxième et troisième modules de centre de données (10, 20, 30) à l'instant prédéterminé.
